# EUROPEAN PATENT APPLICATION

(11) **EP 2 667 409 A1**
(43) Date of publication of application: **27.11.2013**
(21) Application number: 12168696.8
(22) Date of filing: 21.05.2012
(51) Int. Cl.: H01L 23/66

(54) **Amplifier circuit with a low inductance bond wire arrangement**

(71) Applicant: NXP B.V., 5656 AG Eindhoven (NL)
(72) Inventor: Van der Heijden, Mark, 5656 AG Eindhoven (NL); Acar, Mustafa, 5656 AG Eindhoven (NL); Apostolidou, Melina, 5656 AG Eindhoven (NL); De Langen, Michel, 5656 AG Eindhoven (NL)
(74) Representative: Schouten, Marcus Maria

(57) **Abstract**

An amplifier circuit is disclosed. The amplifier circuit comprises an amplifier IC (22); a control IC (24); a signal connections connected between the amplifier IC (22) and the control IC (24), the signal connections (44, 54) being adapted to communicate control signals between the control IC (24) and the amplifier IC (22); and a reference connections (42, 52) connected between the amplifier IC (22) and the control IC (24), the reference connections (42, 52) being adapted to communicate a reference voltage between the amplifier IC (22) and the control IC (24). The reference connections (42, 52) are substantially parallel to the signal connections (44 , 52). Both the reference connections (42, 52) and the signal connections (44, 54) are comprised of either wire or ribbon bonds.

## Description

This invention relates to an amplifier circuit, and more particularly to an amplifier circuit having a control circuit.

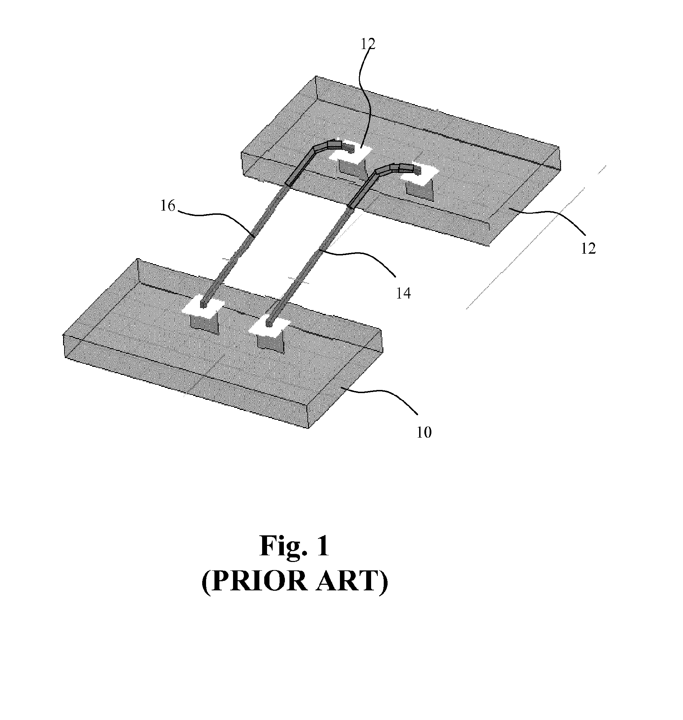

An example of a conventional switch mode power amplifier (PA) circuit is illustrated in Figure 1.

A control integrated circuit (IC) 10 is connected to a power amplifier IC 12 via first 14 and second 16 wire bond connections. The first 14 and second 16 wire bond connections supply control or drive signals from the driver IC 10 to the PA IC 12 so as to control operation of the PA IC 12. Accordingly, the wires forming the wire bond connections are typically referred to as signal bond wires.

When the control signals comprise a pulse waveform, the conventional arrangement of signal bond wires shown in Fig. 1 causes pulse deterioration at high operating frequencies. This is due to the signal bond wire arrangement low-pass filtering the higher harmonics of the pulse waveform.

According to an aspect of the invention there is provided an amplifier circuit according to the independent claim.

Embodiments propose the implementation of an interface between a control circuit and an amplifier which may lower the effective inductance between the control circuit and amplifier. Such an interface may provide a ground return path situated close to the signal connection. Mutual inductance between such signal and ground connections lowers the effective inductance between the driver circuit and amplifier, thus improving bandwidth performance.

Accordingly, embodiments may provide improved bandwidth performance compared to conventional amplifier circuits, thereby enabling optimal transfer of pulsed control signals from the control circuit to the amplifier.

Examples of the invention will now be described in detail with reference to the accompanying drawings, in which:
Figure 1 is a diagram of a conventional switch mode power amplifier circuit;
Figure 2 is a diagram of an amplifier circuit according to a first embodiment of the invention;
Figure 3 is a diagram of an amplifier circuit according to a second embodiment of the invention;
Figure 4 is a diagram of an amplifier circuit according to a third embodiment of the invention;
Figures 5A and 5B illustrate simulation results of a conventional amplifier circuit, wherein a control signal is pulsed at a frequency of 2GHz and 3GHz respectively; and
Figures 6A and 6B illustrate simulation results of the embodiment of Figure 3, wherein a control signal is pulsed at a frequency of 2GHz and 3GHz respectively.

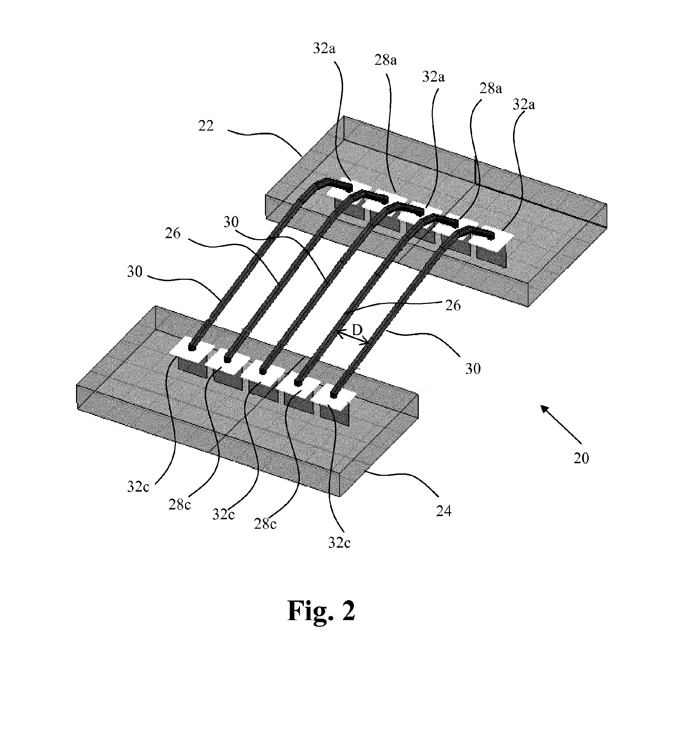

Referring to Figure 2, there is shown an amplifier circuit 20 according to a first embodiment of the invention. The amplifier circuit 20 comprises a switch-mode power amplifier IC 22 and a control IC 24. A signal connection 26 is connected between the amplifier IC 22 and the control IC 24.

The signal connection 26 comprises a plurality of spaced apart and substantially parallel signal bond wires 26 (i.e. wire bond connections) connected between corresponding signal bond pads 28a and 28c of the amplifier IC 22 and control IC 24 respectively. In this way, the signal connection 26 is adapted to communicate control signals between the control IC 24 and the amplifier IC 22.

The amplifier circuit 20 also comprises a reference connection 30 connected between the amplifier IC 22 and the control IC 24, wherein the reference connection is adjacent the signal connection 26

More specifically, the reference connection 30 comprises a plurality of spaced apart and substantially parallel reference bond wires 30 (i.e. wire bond connections) connected between corresponding reference bond pads 32a and 32c of the amplifier IC 22 and control IC 24 respectively. The reference bond pads 32a and 32c are connected to a ground reference voltage (i.e. zero (0) volts). In this way, the reference connection 30 is adapted to share the ground reference voltage between the amplifier IC 22 and the control IC 24.

Here, the parallel reference bond wires 30 are arranged such that the parallel signal bond wires 26 are alternately interspaced between the parallel reference bond wires 30. In other words, the connections between the amplifier IC 22 and control IC 24 are arranged in a parallel coplanar array with the connections alternating between a reference connection 30 (e.g. a reference bond wire 30) and a signal connection 26 (e.g. a signal bond wire 26) along the array.

It is noted that the outer connections of the array (i.e. the first and last connections in the row of connections) are each formed from a reference bond wire 30. As a result, each signal bond wire 26 is adjacent, and parallel, to two reference bond wires 30. In other words, on either side of a signal bond wire 26 there is provided a parallel reference bond wire 30.

The above-detailed arrangement of the reference connection 30 and the signal connection 26 results in the signal bond wires 26 being coupled to the reference bond wires 30 by mutual inductance. With the reference bond wires 30 being connected to ground, the reference bond wires 30 effectively provide ground return paths that are close to the signal bond wires 26 (i.e. the signal lines).

By way of example, the distance D between the central axis of a reference bond wire 30 and the central axis of an adjacent signal bond wire 26 (i.e. the pitch of the wire bond connections) in this first embodiment is approximately 135µm. With the thickness of each bond wire being approximately 25µm, it will be appreciated that the distance between adjacent bond wires is approximately 110µm. The mutual inductance between the signal bond wires 26 and the reference bond wires 30 lowers the effective inductance between the amplifier IC 22 and the control IC 24, thus providing improved bandwidth performance.

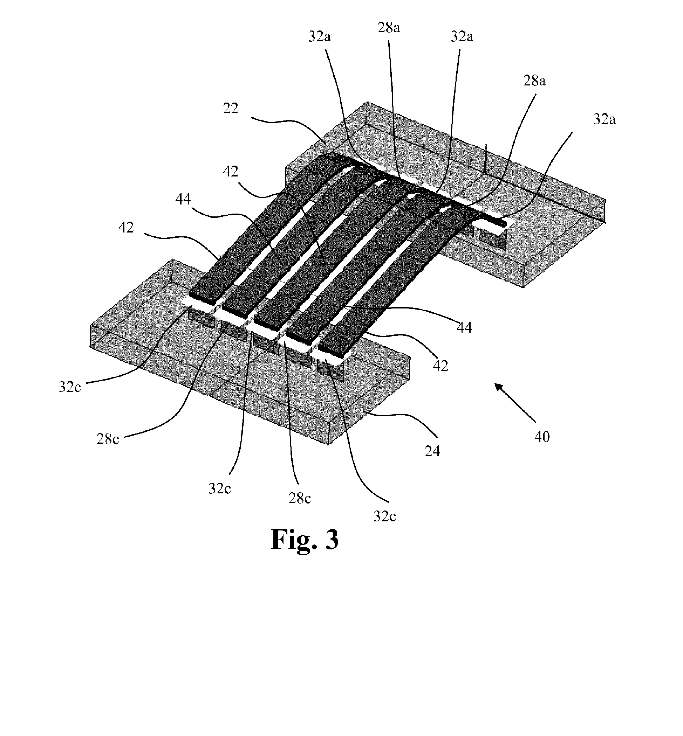

Referring now to Figure 3, there is shown an amplifier circuit 40 according to a second embodiment of the invention. This second embodiment represents a modification of the first embodiment, wherein the wire bond connections (i.e. the bond wires) have been replaced with ribbon bond connections. Thus, the arrangement of the first embodiment (shown in Figure 2) is the same as that of the second embodiment (shown in Figure 3), except that the reference connection 42 and the signal connection 44 are each formed from a plurality of spaced apart and substantially parallel bond ribbons (instead of bond wires).

Just as in the first embodiment (shown in Figure 1), the connections between the amplifier IC 22 and control IC 24 of the second embodiment (shown in Figure 2) are arranged in a parallel coplanar array, with the connections alternating between a reference connection 42 (i.e.. a reference bond ribbon 42) and a signal connection 44 (i.e. a signal bond ribbon 44) along the coplanar array.

By way of example, the distance between the central axis of a reference bond ribbon 42 and the central axis of an adjacent signal bond ribbon 44 (in other words the pitch of the ribbon bond connections) in this second embodiment is approximately 135µm (i.e. the same as that of the first embodiment). However, with the width of each bond ribbon being approximately 100µm, it will be appreciated that the distance between the adjacent edges of adjacent bond ribbons is approximately 35µm. Thus, compared to the first embodiment (employing wire bonds), the second embodiment (employing ribbon bonds) has greater mutual inductance between the signal connection 44 and the reference connection 42, thereby further lowering the effective inductance between the amplifier IC 22 and the control IC 24.

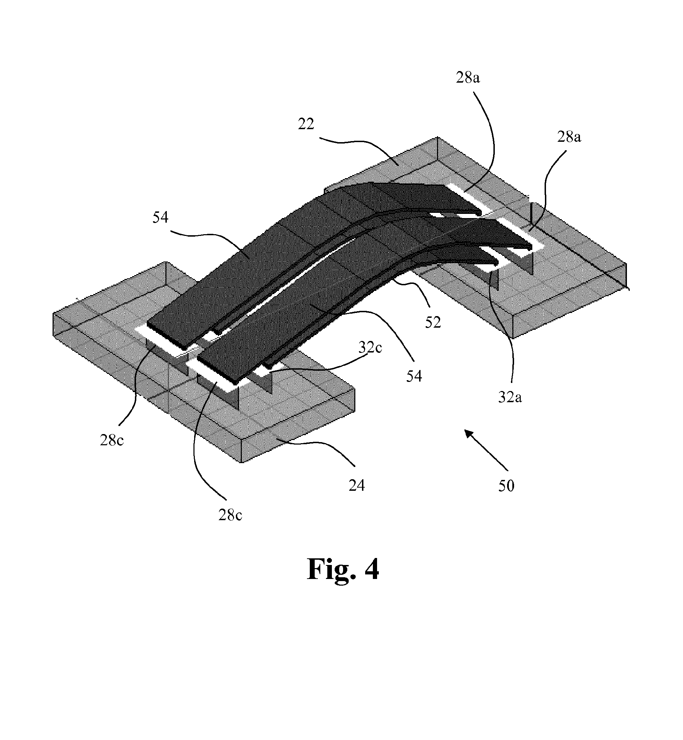

Referring now to Figure 4, there is shown an amplifier circuit 50 according to a third embodiment of the invention. This third embodiment represents a modification of the second embodiment, wherein the ribbon bond connections (i.e. the bond ribbon) are no longer arranged in a coplanar array, but instead each of the reference bond ribbons 52 is arranged to be directly below a respective signal bond ribbon 54.

As illustrated in Figure 4, the signal connections 54 between the amplifier IC 22 and control IC 24 are arranged in a first coplanar array, and the reference connections 52 between the amplifier IC 22 and control IC 24 are arranged in a second coplanar array which is parallel to and below the first coplanar array. Thus, pairs of vertically aligned bond ribbons are formed, wherein each pair comprises a reference bond ribbon 52 vertically aligned below a signal bond ribbon 54.

By way of example, the distance between the central axis of adjacent signal bond ribbons 54 (in other words the pitch of the signal ribbon bond connections) in this third embodiment is approximately 270µm (i.e. twice that of the first and second embodiments). Likewise, the distance between the central axis of adjacent reference bond ribbons 52 (in other words the pitch of the reference bond connections) in this third embodiment is also approximately 270m. Further, the vertical space between a reference bond ribbon 52 and a vertically adjacent signal bond ribbon 54 is 50µm.

As already explained with the previous embodiments, mutual inductance between the pairs of vertically aligned bond ribbons again reduces the effective inductance between the amplifier IC 22 and the control IC 24.

It is noted that in this third embodiment, the signal bond ribbons 54 need to be higher and longer than the reference bond ribbons 52. However, it has been found that the higher coupling of the arrangement mitigates any increase in inductance due to the longer signal bond ribbons.

By way of example, the performance of the second embodiment (shown in Figure 3) has been compared the conventional amplifier circuit of Figure 1. For this comparison, a conventional control IC was employed with a conventional amplifier IC, wherein the total distance between the lCs was 0.7 mm (resulting in a typical bond distance of 1mm between a signal output pad of the control IC driver and the signal input pad of the amplifier IC).

Simulation of the conventional amplifier circuit and the second embodiment was undertaken with an RLC, slightly underdamped (ζ = 0.7),

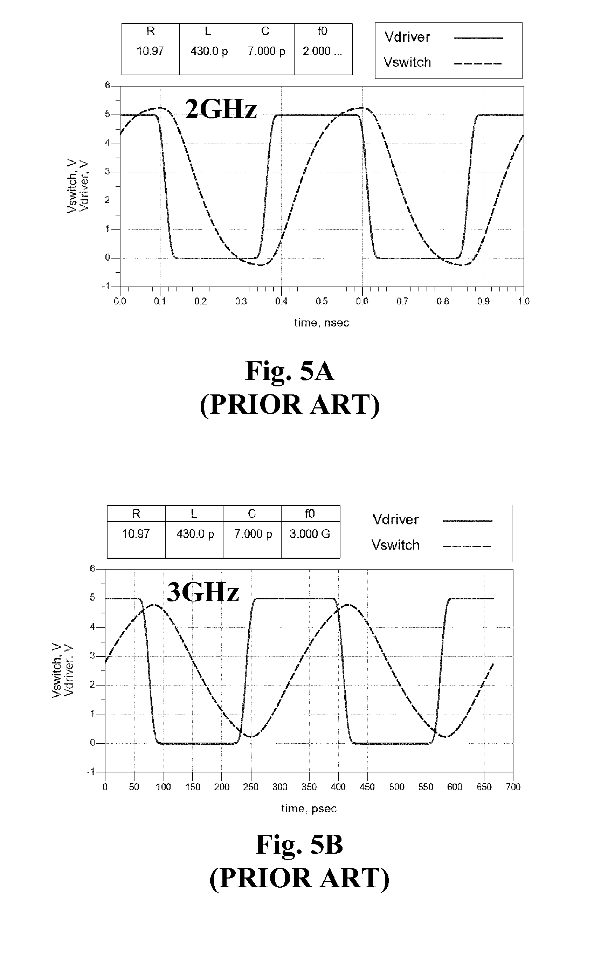

Figures 5A and 5B illustrate the simulation results of the conventional amplifier circuit, wherein a control signal is pulsed at a frequency of 2GHz and 3GHz respectively. From the simulation results, it was found that the effective inductance L between the amplifier IC and the control IC was 0.43 nH. Furthermore, at 3 GHz, the pulse was deteriorated.

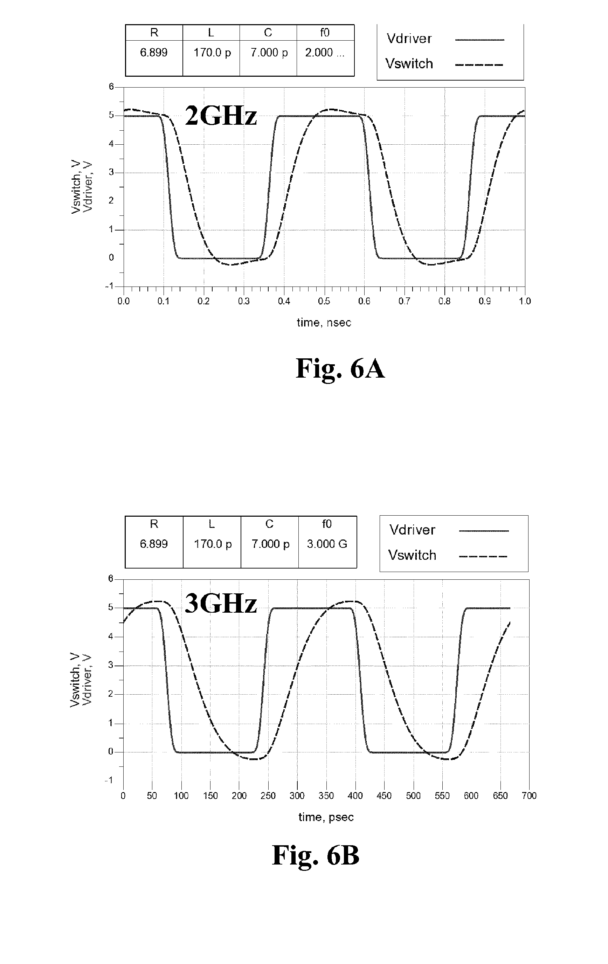

Figures 6A and 6B illustrate simulation results of the second embodiment (shown in Figure 3), wherein a control signal is pulsed at a frequency of 2GHz and 3GHz respectively. From the simulation results, it was found that the effective inductance L between the amplifier IC and the control IC was 0.17nH. Furthermore, at 3 GHz, the pulse was of an acceptable quality.

Such simulations were also undertaken for the first and third embodiment, and the simulation results for a control signal pulsed at a frequency of 2GHz are summarised in Table 1 below.

**Table 1**

| | **Effective inductance (nH)** | **Mutual coupling coefficient k** |
|---|---|---|
| Conventional Amplifier Circuit | 0.43 | n.a. |
| Embodiment 1 | 0.33 | 0.49 |
| Embodiment 2 | 0.17 | 0.68 |
| Embodiment 3 | 0.17 | 0.75 |

From the simulation results, it is noted that the effective inductance L between the amplifier IC and the control IC is reduced in the first to third embodiments of the invention.

It is also noted that the effective inductance of the third embodiment is equal to that of the second embodiment even the signal ribbon bonds of the third embodiment are longer and higher. It may therefore be concluded that the increased length and height of the signal bond ribbons of the third embodiment are compensated for by the higher coupling coefficient between the pairs of vertically aligned bond ribbons

Various modifications will be apparent to those skilled in the art.

## Claims

1. An amplifier circuit comprising:
an amplifier;
a control circuit;
a signal connection connected between the amplifier and the control circuit, the signal connection being adapted to communicate control signals between the control circuit and the amplifier; and
a reference connection connected between the amplifier and the control circuit, the reference connection being adapted to communicate a reference voltage between the amplifier and the control circuit,
wherein the reference connection is adjacent the signal connection.

2. The circuit of claim 1, wherein the reference connection is spaced apart from the signal connection so as to be coupled by mutual inductance to the signal connection.

3. The circuit of claim 2, wherein the reference connection is substantially parallel to the signal connection.

4. The circuit of any preceding claim, wherein at least one of the signal connection and the reference connection comprises a wire bond connection.

5. The circuit of any of claims 1 to 3, wherein at least one of the signal connection and the reference connection comprises a ribbon bond connection.

6. The circuit of any preceding claim, wherein the reference connection comprises a plurality of spaced apart reference connection lines, and wherein the signal connection comprises a plurality of spaced apart signal lines.

7. The circuit of claim 6, wherein the plurality of spaced apart reference connection lines are vertically offset from the plurality of spaced apart signal lines.

8. The circuit of claim 7, wherein the plurality of spaced apart reference connection lines are horizontally aligned with the plurality of spaced apart signal lines.

9. The circuit of any of claims 1 to 6, wherein the plurality of spaced apart signal lines are interspaced between the plurality of spaced apart reference connection lines.

10. The circuit of any preceding claim, wherein the amplifier circuit is a switch-mode amplifier integrated circuit.
